# EUROPEAN PATENT APPLICATION

(11) **EP 4 779 637 A1**
(43) Date of publication of application: **22.07.2026**
(21) Application number: 26151906.0
(22) Date of filing: 14.01.2026
(51) Int. Cl.: G11C 5/06, H10B 41/27, H10B 43/27, H10B 41/10, H10B 41/50, H10B 43/10, H10B 43/50

(54) **MEMORY DEVICE INCLUDING BIT LINES**

(30) Priority: 17.01.2025 KR 20250007554
(71) Applicant: Samsung Electronics Co., Ltd., Suwon-si, Gyeonggi-do 16677 (KR)
(72) Inventor: LEE, Haemin, 16677 Suwon-si (KR); KIM, Kyungdong, 16677 Suwon-si (KR); LEE, Seunghyun, 16677 Suwon-si (KR); KANAMORI, Kohji, 16677 Suwon-si (KR); HAN, Jeehoon, 16677 Suwon-si (KR)
(74) Representative: Marks & Clerk LLP

(57) **Abstract**

A memory device is disclosed. The memory device includes a peripheral circuit area, a first cell area disposed on the peripheral circuit area and including a plurality of lower bit lines and a plurality of bypass bit lines, the lower bit lines including a first lower bit line including a first segment and a second segment spaced apart from each other with a line cut region therebetween and a second lower bit line spaced apart from the first lower bit line in a first horizontal direction and extending in a second horizontal direction, and the plurality of bypass bit lines being spaced apart from each other in the second horizontal direction in the line cut region, and a second cell area including a plurality of upper bit lines electrically connected to the bypass bit lines and being disposed between the peripheral circuit area and the second cell area.

## Description

### BACKGROUND

The inventive concept relates to a memory device, and more particularly, to a memory device having a memory string disposed in a vertical direction.

In electronic systems requiring data storage, memory devices capable of storing large quantities of data are required. As one of the methods for increasing the data storage capacity of a memory device, a memory device including three-dimensionally arranged memory cells instead of two-dimensionally arranged memory cells has been proposed. In addition, a memory device has been proposed in which a portion of the memory device is formed on a first substrate, another portion of the memory device is formed on a second substrate, and the first substrate and the second substrate are bonded to each other.

### SUMMARY

The inventive concept provides a memory device having excellent operation characteristics and an improved degree of integration.

According to an aspect of the inventive concept, there is provided a memory device including a peripheral circuit area, a first cell area disposed at a vertical level different from that of the peripheral circuit area and including a plurality of lower bit lines and a plurality of bypass bit lines, the plurality of lower bit lines including a first lower bit line including a first segment and a second segment spaced apart from each other with a line cut region therebetween and a second lower bit line spaced apart from the first lower bit line in a first horizontal direction and extending in a second horizontal direction, and the plurality of bypass bit lines being spaced apart from each other in the second horizontal direction in the line cut region, and a second cell area including a plurality of upper bit lines electrically connected to the plurality of bypass bit lines, the first cell area being disposed between the peripheral circuit area and the second cell area.

According to another aspect of the inventive concept, there is provided a memory device including a peripheral circuit area, a first cell area disposed on the peripheral circuit area and including a plurality of lower bit lines and a plurality of bypass bit lines, the plurality of lower bit lines including a cut lower bit line including a first segment and a second segment spaced apart from each other with a line cut region therebetween and one or more normal bit lines spaced apart from the cut lower bit line in a first horizontal direction and extending in a second horizontal direction, and the plurality of bypass bit lines being spaced apart from each other in the second horizontal direction in the line cut region, and a second cell area disposed on the first cell area and including a plurality of upper bit lines electrically connected to the plurality of bypass bit lines.

According to another aspect of the inventive concept, there is provided a memory device including a peripheral circuit area, a first cell area disposed on the peripheral circuit area and including a plurality of lower bit lines, a plurality of bypass bit lines, and a lower connection line, the plurality of lower bit lines including a cut lower bit line including a first segment and a second segment spaced apart from each other with a line cut region therebetween and one or more normal bit lines spaced apart from the cut lower bit line in a first horizontal direction and extending in a second horizontal direction, the plurality of bypass bit lines being spaced apart from each other in the second horizontal direction in the line cut region, and the lower connection line being spaced apart from the first segment and the second segment in the first horizontal direction and electrically connecting the first segment to the second segment, and a second cell area disposed on the first cell area and including a plurality of upper bit lines electrically connected to the plurality of bypass bit lines.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIG. 1 is a block diagram of a memory device according to embodiments;
FIG. 2 is a circuit diagram illustrating a memory block according to embodiments;
FIG. 3 schematically illustrates a structure of a memory device according to embodiments;
FIG. 4 illustrates a memory device according to embodiments;
FIG. 5 is a perspective view illustrating a memory device according to embodiments;
FIG. 6 is a cross-sectional view schematically illustrating the memory device of FIG. 5;
FIG. 7 is a perspective view schematically illustrating a bit line connection structure of the memory device of FIG. 5;
FIG. 8 is a plan layout diagram illustrating an arrangement of lower bit lines of FIG. 7;
FIG. 9 is a plan layout diagram illustrating an arrangement of upper bit lines of FIG. 7;
FIG. 10 is a cross-sectional view illustrating a memory device according to embodiments;
FIG. 11 is a perspective view schematically illustrating a bit line connection structure of the memory device of FIG. 10;
FIG. 12 is a plan layout diagram illustrating an arrangement of lower bit lines of FIG. 11;
FIG. 13 is a plan layout diagram illustrating an arrangement of upper bit lines of FIG. 11;
FIG. 14 is a cross-sectional view illustrating a memory device according to embodiments;
FIG. 15 is a perspective view schematically illustrating a bit line connection structure of the memory device of FIG. 14;
FIG. 16 is a plan layout diagram illustrating an arrangement of lower bit lines of FIG. 14;
FIG. 17 is a plan layout diagram illustrating an arrangement of upper bit lines of FIG. 14;
FIG. 18 is a cross-sectional view illustrating a memory device according to embodiments;
FIG. 19 is a perspective view schematically illustrating a bit line connection structure of the memory device of FIG. 18;
FIG. 20 is a cross-sectional view illustrating a memory device according to embodiments; and
FIG. 21 is a perspective view schematically illustrating a bit line connection structure of the memory device of FIG. 20.

### DETAILED DESCRIPTION OF THE EMBODIMENTS

Hereinafter, embodiments are described in detail with reference to the accompanying drawings.

As used herein, the singular forms "a", "an", and "the" are intended to include the plural forms as well, unless the context clearly indicates otherwise. Additionally, the description may be specific to a portion of the memory device and the described structure may be repeated in other portions of the memory device. For example, the described structure may be an individual element of an array of elements forming the memory device. Accordingly, where the structure of a single element of a plurality of elements has been described, this structure may equally apply to other elements of the plurality of elements.

The term "overlap" (or "overlapping", or like terms), as may be used herein, is intended to broadly refer to a first element that intersects with at least a portion of a second element when viewed in a particular direction (e.g., in a vertical direction), but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

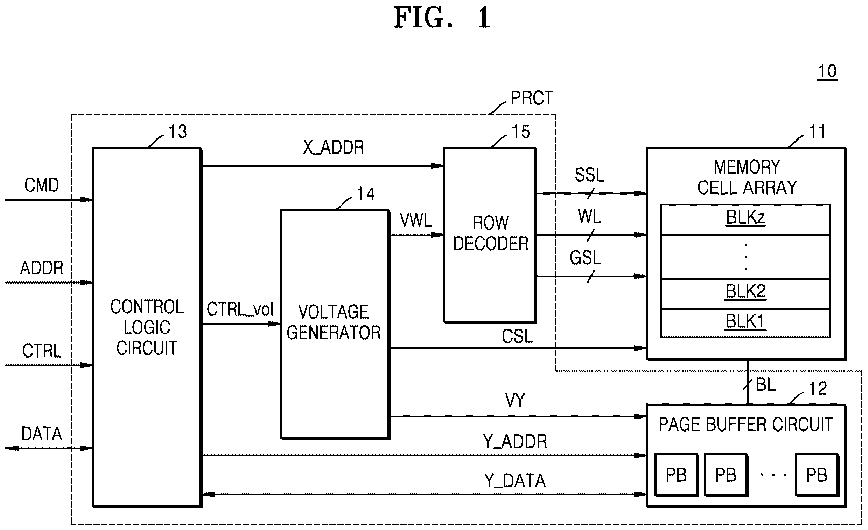

FIG. 1 is a block diagram of a memory device 10 according to embodiments.

Referring to FIG. 1, the memory device 10 may include a memory cell array 11 and a peripheral circuit PRCT, and the peripheral circuit PRCT may include a page buffer circuit 12, a control logic circuit 13, a voltage generator 14, and a row decoder 15. Although not shown in FIG. 1, the peripheral circuit PRCT may further include a data input/output circuit, an input/output interface, or the like. In addition, the peripheral circuit PRCT may further include a temperature sensor, a command decoder, an address decoder, and the like. In the specification, the memory device 10 may be referred to as a non-volatile memory device.

The memory cell array 11 may include a plurality of memory blocks BLK1 to BLKz (z is a positive integer), and each of the plurality of memory blocks BLK1 to BLKz may include memory cells. The memory cell array 11 may be connected to the page buffer circuit 12 through bit lines BL, connected to the voltage generator 14 through a common source line CSL, and connected to the row decoder 15 through word lines WL, string select lines SSL, and ground select lines GSL. For example, the memory cells may be flash memory cells. Hereinafter, the embodiments are described in detail by assuming that the memory cells are NAND flash memory cells. However, the inventive concept is not limited thereto, and in some embodiments, the memory cells may be resistive memory cells, such as resistive random access memory (ReRAM), phase change random access memory (PRAM), or magnetic random access memory (MRAM).

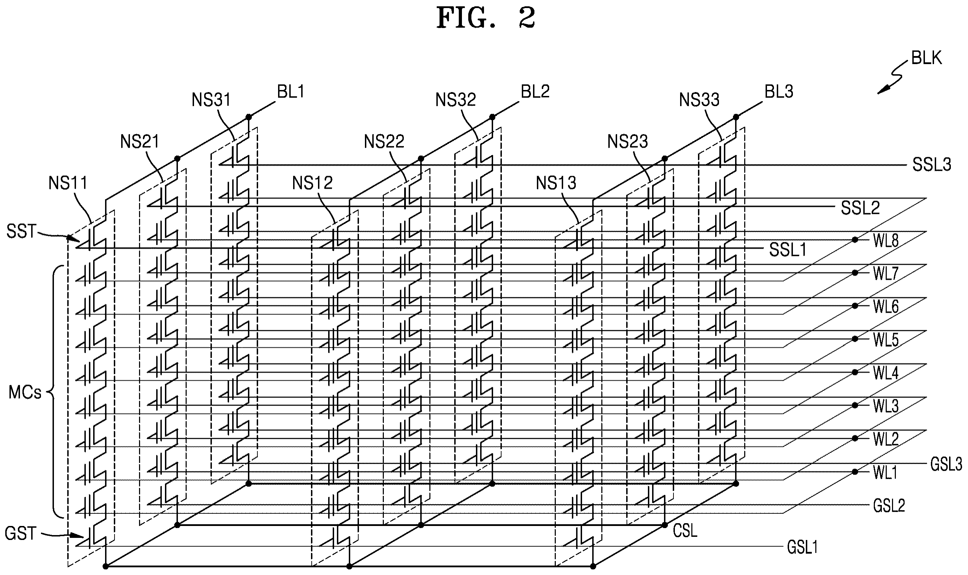

In an embodiment, the memory cell array 11 may include a three-dimensional memory cell array, the three-dimensional memory cell array may include a plurality of NAND strings, each NAND string may include memory cells respectively connected to word lines vertically stacked on a substrate, and this embodiment is described in detail with reference to FIG. 2. However, the inventive concept is not limited thereto, and in some embodiments, the memory cell array 11 may include a two-dimensional memory cell array, and the two-dimensional memory cell array may include a plurality of NAND strings arranged in row and column directions.

The page buffer circuit 12 may include a plurality of page buffers PB. Each of the plurality of page buffers PB may be connected to memory cells in the memory cell array 11 through a corresponding bit line BL. The page buffer circuit 12 may select at least one of the bit lines BL under control by the control logic circuit 13. For example, the page buffer circuit 12 may select some of the bit lines BL in response to a column address Y_ADDR received from the control logic circuit 13 and control voltages VY output from the voltage generator 14. Each of the plurality of page buffers PB may operate as a write driver or a sense amplifier. For example, in a program operation, each of the plurality of page buffers PB may store data DATA to be programmed in a memory cell by applying, to a bit line BL, a voltage corresponding to data Y_DATA obtained by internally processing the data DATA to be programmed through the control logic circuit 13. For example, in a program verify operation or a read operation, each of the plurality of page buffers PB may sense the data DATA, which has been programmed, by internally processing, through the control logic circuit 13, the data Y_DATA sensed by sensing a current or a voltage through a bit line BL.

The control logic circuit 13 may output various kinds of control signals, e.g., a voltage control signal CTRL_vol, a row address X_ADDR, and the column address Y_ADDR, for programming data on the memory cell array 11, reading data from the memory cell array 11, or erasing data stored in the memory cell array 11 based on a command CMD, an address ADDR, the data DATA, and a control signal CTRL. Accordingly, the control logic circuit 13 may generally control various kinds of operations in the memory device 10. For example, the control logic circuit 13 may receive the command CMD, the address ADDR, the data DATA, and the control signal CTRL from a memory controller.

The voltage generator 14 may generate various kinds of voltages for performing program, read, and erase operations on the memory cell array 11 based on the voltage control signal CTRL_vol. Particularly, the voltage generator 14 may generate a word line voltage VWL, e.g., a program voltage, a read voltage, a pass voltage, an erase verify voltage, a program verify voltage, or the like, and generate the control voltages VY, e.g., a transistor gate voltage for supplying a bit line voltage and the like, for the page buffer circuit 12. In addition, the voltage generator 14 may further generate a string select line SSL voltage, a ground select line GSL voltage, and a common source line CSL voltage based on the voltage control signal CTRL_vol.

In response to the row address X_ADDR received from the control logic circuit 13, the row decoder 15 may select one of the plurality of memory blocks BLK1 to BLKz, select one of the word lines WL of the selected memory block, and select one of the string select lines SSL. For example, in a program operation, the row decoder 15 may apply the program voltage and the program verify voltage to the selected word line WL, and in a read operation, the row decoder 15 may apply the read voltage to the selected word line WL.

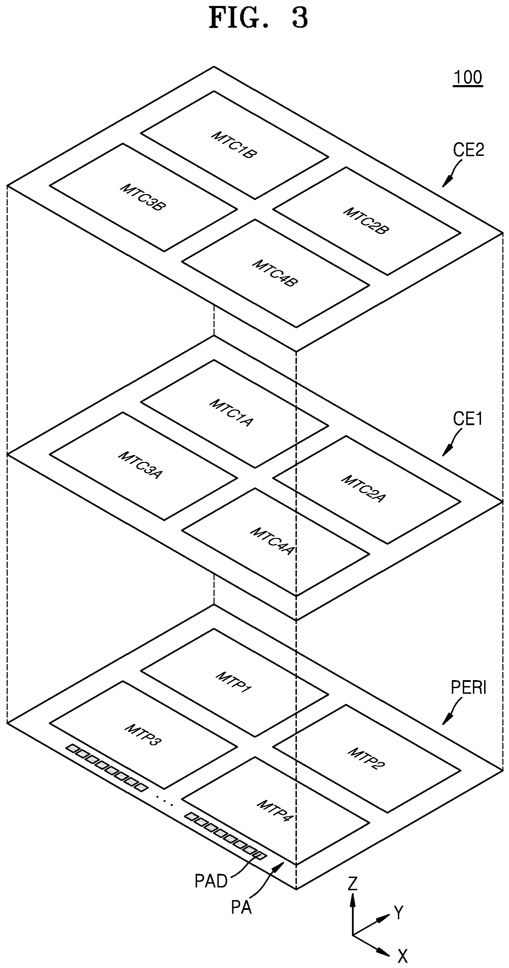

According to an embodiment, the memory cell array 11 may be disposed in a first cell area CE1 (see FIG. 3) and a second cell area CE2 (see FIG. 3), and the peripheral circuit PRCT may be disposed in a peripheral circuit area PERI (see FIG. 3). In this case, at least a portion of the peripheral circuit PRCT may overlap the memory cell array 11 in a vertical direction (e.g., a direction in which the peripheral circuit PRCT, the first cell area CE1 and the second cell area CE2 are stacked).

FIG. 2 is a circuit diagram illustrating a memory block BLK according to embodiments.

Referring to FIG. 2, the memory block BLK may correspond to one of the plurality of memory blocks BLK1 to BLKz of FIG. 1. The memory block BLK may include NAND strings NS11 to NS33, and each NAND string (e.g., NS11) may include a string select transistor SST, a plurality of memory cells MCs, and a ground select transistor GST, which are connected in series. The transistors (the string select transistor SST and the ground select transistor GST) and the plurality of memory cells MCs included in each NAND string may form a structure of being stacked on a substrate in the vertical direction.

First to third bit lines BL1 to BL3 may extend in a first direction (for example, the Y direction of FIG. 3), and word lines WL1 to WL8 may extend in a second direction (for example, the X direction of FIG. 3). According to an embodiment, the first direction may be referred to a first horizontal direction, and the second direction may be referred to a second horizontal direction. The NAND strings NS11, NS21, and NS31 may be positioned between the first bit line BL1 and the common source line CSL, the NAND strings NS12, NS22, and NS32 may be positioned between the second bit line BL2 and the common source line CSL, and the NAND strings NS13, NS23, and NS33 may be positioned between the third bit line BL3 and the common source line CSL.

The string select transistor SST may be connected to a corresponding string select line SSL1, SSL2, or SSL3. The plurality of memory cells MCs may be connected to corresponding word lines WL1 to WL8, respectively. The ground select transistor GST may be connected to a corresponding ground select line GSL1, GSL2, or GSL3. The string select transistor SST may be connected to a corresponding bit line, and the ground select transistor GST may be connected to the common source line CSL. Herein, the number of NAND strings, the number of word lines, the number of bit lines, the number of ground select lines, and the number of string select lines may be variously changed according to embodiments.

FIG. 3 schematically illustrates a structure of a memory device 100 according to embodiments.

Referring to FIG. 3, the memory device 100 may include the peripheral circuit area PERI, the first cell area CE1, and the second cell area CE2 disposed in a vertical direction Z. For example, the peripheral circuit area PERI may include first to fourth peripheral circuit mats MTP1, MTP2, MTP3, and MTP4 arranged in a matrix form. Each of the first to fourth peripheral circuit mats MTP1, MTP2, MTP3, and MTP4 may include the peripheral circuit PRCT described with reference to FIG. 1. The peripheral circuit area PERI may include a pad region PA in a partial region of the peripheral circuit area PERI (e.g., an edge of the peripheral circuit area PERI), and a pad PAD may be arranged in the pad region PA. The pad PAD may be an input/output terminal configured to receive power or a signal from an external device and supply the same to the first to fourth peripheral circuit mats MTP1, MTP2, MTP3, and MTP4 in the peripheral circuit area PERI.

The first cell area CE1 may include first to fourth lower memory mats MTC1A, MTC2A, MTC3A, and MTC4A arranged in a matrix form. The first to fourth lower memory mats MTC1A, MTC2A, MTC3A, and MTC4A may be arranged at positions vertically overlapping the first to fourth peripheral circuit mats MTP1, MTP2, MTP3, and MTP4, respectively. Each of the first to fourth lower memory mats MTC1A, MTC2A, MTC3A, and MTC4A may include the memory cell array 11 described with reference to FIG. 1.

The second cell area CE2 may include first to fourth upper memory mats MTC1B, MTC2B, MTC3B, and MTC4B arranged in a matrix form. The first to fourth upper memory mats MTC1B, MTC2B, MTC3B, and MTC4B may be arranged at positions vertically overlapping the first to fourth lower memory mats MTC1A, MTC2A, MTC3A, and MTC4A, respectively, and also vertically overlapping the first to fourth peripheral circuit mats MTP1, MTP2, MTP3, and MTP4, respectively. Each of the first to fourth upper memory mats MTC1B, MTC2B, MTC3B, and MTC4B may include the memory cell array 11 described with reference to FIG. 1.

Herein, the terms "lower" and "upper" are used to indicate relative positions of a first component and a second component with reference to the peripheral circuit area PERI. For example, the first lower memory mat MTC1A included in the first cell area CE1 is at a nearer distance from the peripheral circuit area PERI, while the first upper memory mat MTC1B included in the second cell area CE2 is at a farther distance from the peripheral circuit area PERI. Accordingly, the terms "lower" and "higher" may refer to relative distances in the vertical direction Z from the peripheral circuit area PERI. It will be appreciated that these terms (and similar terms, such as horizontal and vertical) are defined relative to the structure of the device, and therefore need not limit the orientation of the device in use. Therefore, when the memory device 100 is provided to an external device and used, a "lower" component may be at a vertical level higher or lower than that of an "upper" component.

Although FIG. 3 shows that the pad PAD is arranged in the pad region PA in the peripheral circuit area PERI, in some embodiments, the pad PAD may be arranged in the second cell area CE2.

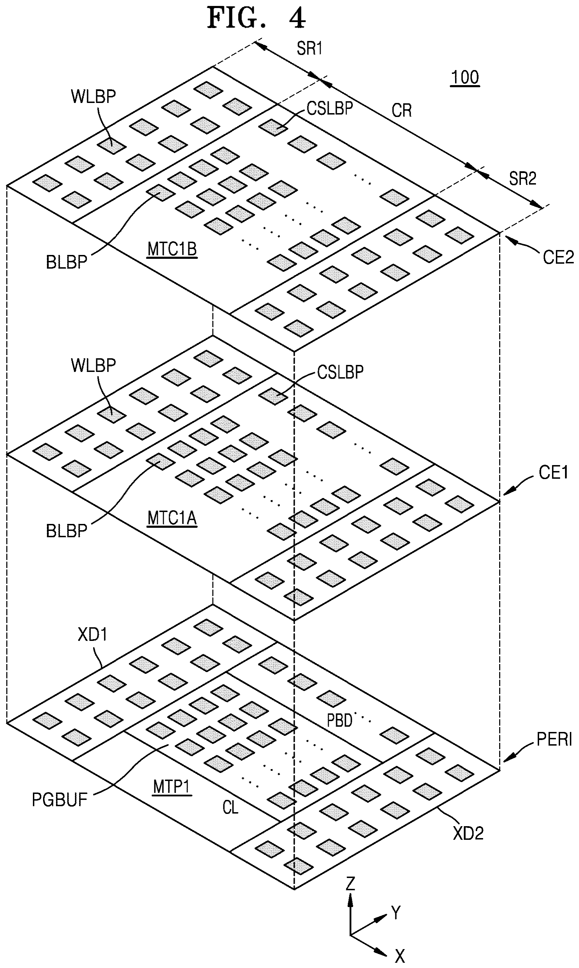

FIG. 4 illustrates the memory device 100 according to embodiments. FIG. 4 schematically illustrates a layout of a portion of the memory device 100, e.g., the first peripheral circuit mat MTP1, the first lower memory mat MTC1A, and the first upper memory mat MTC1B disposed in the vertical direction Z.

Referring to FIG. 4, the first lower memory mat MTC1A may include a cell region CR and connection regions SR1 and SR2 arranged at both sides of the cell region CR. The first upper memory mat MTC1B may include a cell region CR and connection regions SR1 and SR2 arranged at both sides of the cell region CR. The cell region CR of the first upper memory mat MTC1B may be arranged at a position corresponding to or vertically overlapping the cell region CR of the first lower memory mat MTC1A. The connection regions SR1 and SR2 of the first lower memory mat MTC1A may be arranged at positions corresponding to (or vertically overlapping) the connection regions SR1 and SR2 of the first upper memory mat MTC1B, respectively.

In some embodiments, the connection regions SR1 and SR2 may be arranged at one side of or in the middle of the cell region CR.

The first peripheral circuit mat MTP1 may include a page buffer circuit region PGBUF, a page buffer driver region PBD, a control logic circuit region CL, and row decoder regions XD1 and XD2. For example, the page buffer circuit region PGBUF may be a region in which the page buffer circuit 12 described with reference to FIG. 1 is arranged. The control logic circuit region CL may be a region in which the control logic circuit 13 described with reference to FIG. 1 is arranged. The row decoder regions XD1 and XD2 may be regions in which the row decoder 15 described with reference to FIG. 1 is arranged. The row decoder regions XD1 and XD2 may be arranged at positions corresponding to (or vertically overlapping) the connection regions SR1 and SR2 of the first lower memory mat MTC1A and the connection regions SR1 and SR2 of the first upper memory mat MTC1B, respectively.

The first lower memory mat MTC1A may be electrically connected to the first peripheral circuit mat MTP1 via a bit line pad BLBP, a word line pad WLBP, and a common source line pad CSLBP, and the first upper memory mat MTC1B may be electrically connected to the first lower memory mat MTC1A via the bit line pad BLBP, the word line pad WLBP, and the common source line pad CSLBP. Accordingly, a bit line of the first lower memory mat MTC1A and a bit line of the first upper memory mat MTC1B may be electrically connected to the page buffer circuit region PGBUF of the first peripheral circuit mat MTP1 via the bit line pad BLBP. In addition, a word line of the first lower memory mat MTC1A and a word line of the first upper memory mat MTC1B may be electrically connected to the row decoder regions XD1 and XD2 of the first peripheral circuit mat MTP1 via the word line pad WLBP. A common source line of the first lower memory mat MTC1A and a common source line of the first upper memory mat MTC1B may be electrically connected to the page buffer driver region PBD of the first peripheral circuit mat MTP1 via the common source line pad CSLBP.

In some embodiments, in the first lower memory mat MTC1A and the first upper memory mat MTC1, the bit line pad BLBP may be separated and arranged in a plurality of regions.

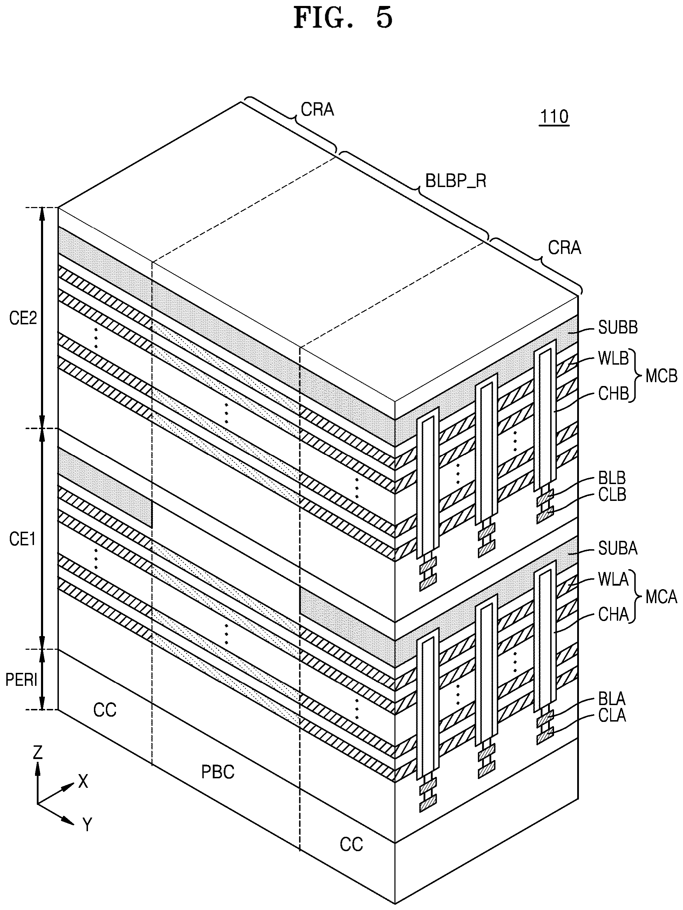

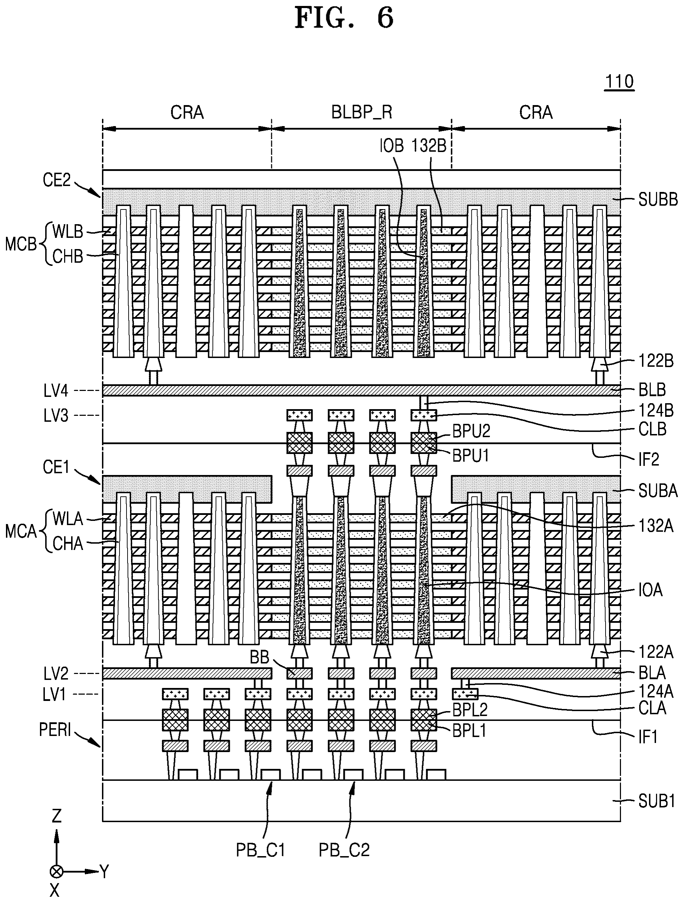

FIG. 5 is a perspective view illustrating a memory device 110 according to embodiments. FIG. 6 is a cross-sectional view schematically illustrating the memory device 110 of FIG. 5.

Referring to FIGS. 5 and 6, the peripheral circuit area PERI, the first cell area CE1, and the second cell area CE2 may be sequentially stacked in the vertical direction Z. A first memory cell array MCA may be arranged in the first cell area CE1, and a second memory cell array MCB may be arranged in the second cell area CE2. A control circuit CC and a page buffer circuit PBC may be arranged in the peripheral circuit area PERI.

Each of the first cell area CE1 and the second cell area CE2 may include a main cell region CRA and a bonding pad region BLBP_R. The peripheral circuit area PERI may be attached to the first cell area CE1 at a first bonding interface IF1 by lower bonding pads BPL1 and BPL2, and the first cell area CE1 may be attached to the second cell area CE2 at a second bonding interface IF2 by upper bonding pads BPU1 and BPU2. The upper bonding pads BPU1 and BPU2 may be arranged in the bonding pad region BLBP_R. In some embodiments, in the memory device 110, the bonding pad region BLBP_R may be separated and arranged in a plurality of regions. Similarly, the main cell region CRA may be separated and arranged in a plurality of regions. The main cell region CRA may be located on opposite sides of the bonding pad region BLBP_R.

A plurality of lower word lines WLA and a lower channel structure CHA extending in the vertical direction Z by passing through the plurality of lower word lines WLA may be arranged in the main cell region CRA of the first cell area CE1. Herein, the plurality of lower word lines WLA and the lower channel structure CHA are referred to as the first memory cell array MCA. The first memory cell array MCA may be electrically connected to a lower bit line BLA.

A plurality of upper word lines WLB and an upper channel structure CHB extending in the vertical direction Z by passing through the plurality of upper word lines WLB may be arranged in the main cell region CRA of the second cell area CE2. Herein, the plurality of upper word lines WLB and the upper channel structure CHB are referred to as the second memory cell array MCB. The second memory cell array MCB may be electrically connected to an upper bit line BLB.

The first memory cell array MCA in the first cell area CE1 may be electrically connected to the lower bit line BLA via a bit line contact 122A, and the lower bit line BLA may be electrically connected to the lower bonding pads BPL1 and BPL2 via a connection via 124A and a lower connection line CLA. The second memory cell array MCB in the second cell area CE2 may be electrically connected to the upper bit line BLB via a bit line contact 122B, and the upper bit line BLB may be electrically connected to the upper bonding pads BPU1 and BPU2 via a connection via 124B and an upper connection line CLB.

A lower through via IOA may be arranged in the bonding pad region BLBP_R of the first cell area CE1. The lower through via IOA may be disposed (e.g., may extend) in the vertical direction Z by passing through a plurality of lower sacrificial layers 132A. The plurality of lower sacrificial layers 132A may be disposed at the same vertical levels as those of the plurality of lower word lines WLA, respectively. The lower sacrificial layers 132A may be remnants of sacrificial layers that were partially removed (e.g., etched) during manufacture (e.g., during the manufacture of the lower word lines WLA). The lower sacrificial layers 132A may be dielectric layers. Accordingly, the lower sacrificial layers 132A may be otherwise known as "lower dielectric layers". A lower substrate layer SUBA may be arranged in the main cell region CRA of the first cell area CE1 and electrically connected to the lower channel structure CHA. The lower substrate layer SUBA may not vertically overlap the bonding pad region BLBP_R.

An upper through via IOB may be arranged in the bonding pad region BLBP_R of the second cell area CE2. The upper through via IOB may be disposed (e.g., may extend) in the vertical direction Z by passing through a plurality of upper sacrificial layers 132B. The plurality of upper sacrificial layers 132B may be disposed at the same vertical levels as those of the plurality of upper word lines WLB, respectively. The upper sacrificial layers 132B may be remnants of sacrificial layers that were partially removed (e.g., etched) during manufacture (e.g., during the manufacture of the upper word lines WLB). The upper sacrificial layers 132B may be dielectric layers. Accordingly, the upper sacrificial layers 132B may be otherwise known as "upper dielectric layers". An upper substrate layer SUBB may be arranged in the main cell region CRA of the second cell area CE2 and electrically connected to the upper channel structure CHB. The upper substrate layer SUBB may vertically overlap the bonding pad region BLBP_R. In some embodiments, the upper through via IOB may not be electrically connected to the upper substrate layer SUBB. In some embodiments, the upper through via IOB may be electrically connected to the upper substrate layer SUBB.

The control circuit CC and the page buffer circuit PBC may be disposed on a substrate SUB1 in the peripheral circuit area PERI. In some embodiments, the page buffer circuit PBC may include a first cell page buffer PB_C1 and a second cell page buffer PB_C2.

The first cell page buffer PB_C1 may indicate a page buffer circuit configured to drive the lower bit line BLA electrically connected to the first memory cell array MCA. The first cell page buffer PB_C1 may be electrically connected to the lower bit line BLA via the lower bonding pads BPL1 and BPL2 (and/or the connection via 124A and the lower connection line CLA).

The second cell page buffer PB_C2 may indicate a page buffer circuit configured to drive the upper bit line BLB electrically connected to the second memory cell array MCB. The second cell page buffer PB_C2 may be electrically connected to bypass bit lines BB via the lower bonding pads BPL1 and BPL2 (and/or the connection via 124A and the lower connection line CLA) and electrically connected to the upper bit line BLB via the lower through via IOA and the upper bonding pads BPU1 and BPU2 (and/or the connection via 124B and the upper connection line CLB).

In embodiments, in the first cell area CE1, the distance between the lower bit line BLA and the peripheral circuit area PERI may be less than the distance between the first memory cell array MCA and the peripheral circuit area PERI. In addition, in the second cell area CE2, the distance between the upper bit line BLB and the peripheral circuit area PERI may be less than the distance between the second memory cell array MCB and the peripheral circuit area PERI.

In embodiments, a front face of the first cell area CE1 may be attached to a front face of the peripheral circuit area PERI, and a front face of the second cell area CE2 may be attached to a rear face of the first cell area CE1. The front face of the first cell area CE1 may be in contact with the front face of the peripheral circuit area PERI at the first bonding interface IF1, and the front face of the second cell area CE2 may be in contact with the rear face of the first cell area CE1 at the second bonding interface IF2. Herein, the front face of the first cell area CE1 indicates the upper surface of the first cell area CE1 adjacent to the lower bit line BLA, and the rear face of the first cell area CE1 indicates the lower surface of the first cell area CE1 adjacent to the lower substrate layer SUBA. In addition, the rear face of the peripheral circuit area PERI indicates the lower surface of the substrate SUB1, and the front face of the peripheral circuit area PERI indicates the upper surface of the peripheral circuit area PERI opposite to the substrate SUB1. Generally, a front face (otherwise known as a front side) of an integrated circuit may refer to a face upon which active components are located, whereas a rear face (otherwise known as a back side) may be opposite to the front face.

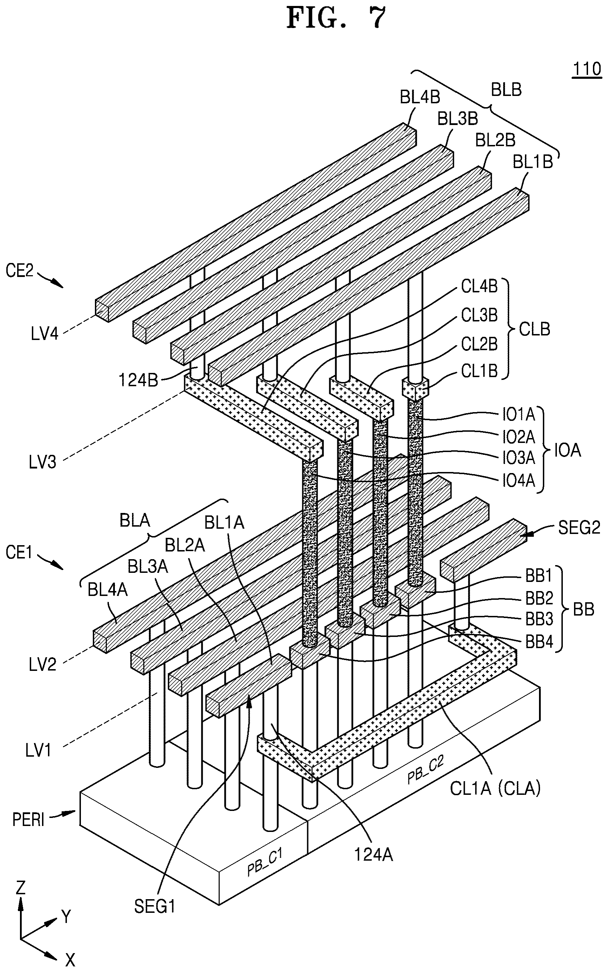

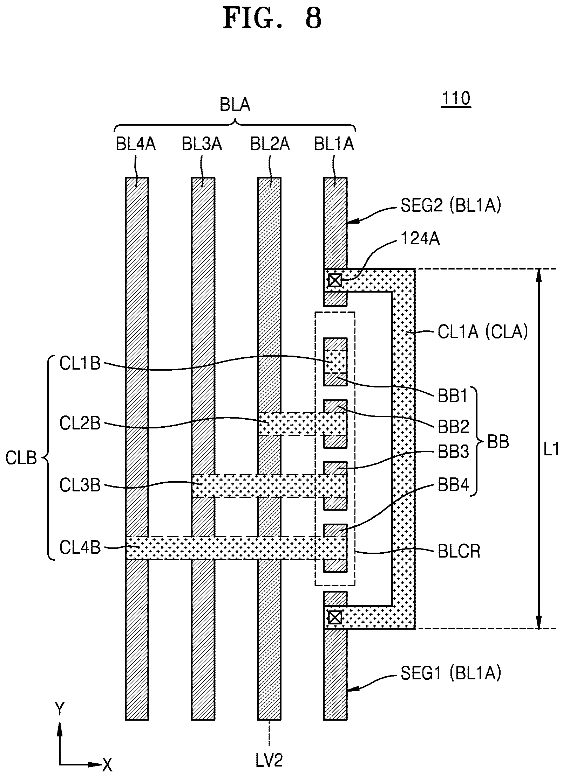

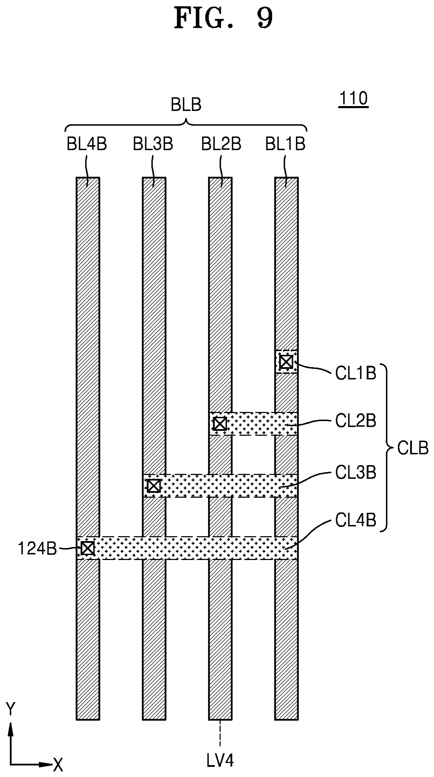

FIG. 7 is a perspective view schematically illustrating a bit line connection structure of the memory device 110 of FIG. 5. FIG. 8 is a plan layout diagram illustrating an arrangement of lower bit lines of FIG. 7. FIG. 9 is a plan layout diagram illustrating an arrangement of upper bit lines of FIG. 7.

Referring to FIGS. 6 to 9, the lower bit line BLA may include first to fourth lower bit lines BL1A, BL2A, BL3A, and BL4A, and the upper bit line BLB may include first to fourth upper bit lines BL1B, BL2B, BL3B, and BL4B. The first to fourth lower bit lines BL1A, BL2A, BL3A, and BL4A may extend in a second horizontal direction Y at a second vertical level LV2, and the first to fourth upper bit lines BL1B, BL2B, BL3B, and BL4B may extend in the second horizontal direction Y at a fourth vertical level LV4 higher than the second vertical level LV2.

In embodiments, the first lower bit line BL1A may include a first segment SEG1 and a second segment SEG2 spaced apart from each other with a line cut region BLCR therebetween. Each of the first segment SEG 1 and the second segment SEG2 may extend in the second horizontal direction Y, and the second segment SEG2 may be spaced apart from and arranged on a straight line with the first segment SEG1 in the second horizontal direction Y. The line cut region BLCR may be arranged in the bonding pad region BLBP_R or arranged to vertically overlap the bonding pad region BLBP_R. The first lower bit line BL1A may be referred to as "a cut bit line" herein in that the first lower bit line BL1A is separated into the first segment SEG1 and the second segment SEG2 by the line cut region BLCR.

In embodiments, the second to fourth lower bit lines BL2A, BL3A, and BL4A may have no line cut region and extend in the second horizontal direction Y at a position overlapping the first lower bit line BL1A in a first horizontal direction X. In embodiments, each of the second to fourth lower bit lines BL2A, BL3A, and BL4A may extend as a single line entirely across the bonding pad region BLBP_R. The second to fourth lower bit lines BL2A, BL3A, and BL4A may be referred to as "an uncut bit line" or "a normal bit line" herein in that the second to fourth lower bit lines BL2A, BL3A, and BL4A have no line cut region and extend as a single line entirely across the bonding pad region BLBP_R.

In embodiments, in the line cut region BLCR, first to fourth bypass bit lines BB1, BB2, BB3, and BB4 may be spaced apart from the first lower bit line BL1A. The first to fourth bypass bit lines BB1, BB2, BB3, and BB4 may be arranged on a straight line in the second horizontal direction Y, and the first to fourth bypass bit lines BB1, BB2, BB3, and BB4 may be arranged on a straight line with the first lower bit line BL1A (for example, with the first segment SEG1 and the second segment SEG2) in the second horizontal direction Y. For example, the first to fourth bypass bit lines BB1, BB2, BB3, and BB4 may be sequentially arranged between the first segment SEG1 and the second segment SEG2. For instance, the first to fourth bypass bit lines BB1, BB2, BB3, and BB4 may be aligned with the first segment SEG1 and the second segment SEG2. The first to fourth bypass bit lines BB1, BB2, BB3, and BB4 may be disposed at the second vertical level LV2 and have upper surfaces at the same vertical level as that of the upper surface of the first lower bit line BL1A.

In embodiments, the first to fourth bypass bit lines BB1, BB2, BB3, and BB4 may be electrically connected to the first to fourth upper bit lines BL1B, BL2B, BL3B, and BL4B of the second cell area CE2, respectively. In embodiments, the second bypass bit line BB2 may be electrically connected to the second upper bit line BL2B via a second lower through via IO2A and a second upper connection line CL2B. In embodiments, the second upper connection line CL2B may extend in the first horizontal direction X at a third vertical level LV3 lower than the fourth vertical level LV4 and have a first end portion in contact with the lower surface of the connection via 124B connected to the second upper bit line BL2B and a second end portion in contact with the upper surface of the second lower through via IO2A. Accordingly, the second upper bit line BL2B and the second bypass bit line BB2 spaced apart from each other in the first horizontal direction X may be electrically connected to each other via the connection via 124B, the second upper connection line CL2B, and the second lower through via IO2A.

In embodiments, the second bypass bit line BB2 may be electrically connected to the second cell page buffer PB_C2 arranged in the peripheral circuit area PERI. In some embodiments, as shown in FIG. 6, the bit line contact 122A may be disposed between the second lower through via IO2A (e.g., the lower through via IOA) and the second bypass bit line BB2 (e.g., a bypass bit line BB). The bit line contact 122A may be formed as a single layer or have a structure in which two or more segments are vertically stacked.

In embodiments, like the second bypass bit line BB2, the third bypass bit line BB3 may be electrically connected to the third upper bit line BL3B via a third lower through via IO3A and a third upper connection line CL3B. The third upper connection line CL3B may be spaced apart from the second upper connection line CL2B in the second horizontal direction Y and extend in the first horizontal direction X. The third bypass bit line BB3 may be electrically connected to the second cell page buffer PB_C2 arranged in the peripheral circuit area PERI. In embodiments, like the second bypass bit line BB2, the fourth bypass bit line BB4 may be electrically connected to the fourth upper bit line BL4B via a fourth lower through via IO4A and a fourth upper connection line CL4B. The fourth upper connection line CL4B may be spaced apart from the third upper connection line CL3B in the second horizontal direction Y and extend in the first horizontal direction X. The fourth bypass bit line BB4 may be electrically connected to the second cell page buffer PB_C2 arranged in the peripheral circuit area PERI. In embodiments, the first bypass bit line BB1 may be electrically connected to the first upper bit line BL1B via a first lower through via IO1A and a first upper connection line CL1B. The first upper connection line CL1B may be spaced apart from the second upper connection line CL2B in the second horizontal direction Y. Each of the first to fourth upper connection lines CL1B to CL4B may be connected to a corresponding one of the first to fourth upper bit lines BL1B to BL4B by a corresponding connection via 124B. In the embodiment of FIG. 7, the first upper connection line CL1B does not extend in the first horizontal direction X; however, in alternative embodiments the first upper connection line CL1B does extend in the first horizontal direction X. The first upper connection line CL1B may be omitted in some embodiments, such that the first bypass bit line BB1 is connected to the first upper bit line BL1B by a single via (e.g., comprising the first lower through via IO1A and the corresponding connection via 124B).

In embodiments, the first segment SEG1 and the second segment SEG2 of the first lower bit line BL1A may be electrically connected to each other via the lower connection line CLA. In embodiments, as shown in FIG. 7, a first lower connection line CL1A may be disposed at a first vertical level LV1, and the first segment SEG1 and the second segment SEG2 may be disposed at the second vertical level LV2 higher than the first vertical level LV1. The first lower connection line CL1A may be spaced apart from the first segment SEG1 and the second segment SEG2 in the first horizontal direction X. The first segment SEG1 and the second segment SEG2 may be electrically connected to the first lower connection line CL1A via the connection via 124A in contact with the lower surface of each of the first segment SEG1 and the second segment SEG2. Accordingly, a bypass electrical path may be formed from the first segment SEG1 to the second segment SEG2 via the connection via 124A in contact with the lower surface of the first segment SEG1, the first lower connection line CL1A, and the connection via 124A in contact with the lower surface of the second segment SEG2.

In embodiments, as shown in FIG. 8, the first lower connection line CL1A may have a first length L1 in the second horizontal direction Y, and the first length L1 may be greater than the length of the line cut region BLCR in the second horizontal direction Y. The first length L1 may vary according to the number of bypass bit lines BB, the separation distance between the bypass bit lines BB, and/or the length of each of the bypass bit lines BB in the second horizontal direction Y.

As an example, the memory device 110 described with reference to FIGS. 5 to 9 is illustratively shown for a case where four bypass bit lines BB are arranged in one line cut region BLCR. In this case, the first to fourth lower bit lines BL1A, BL2A, BL3A, and BL4A may form a lower bit line unit, and the lower bit line unit may be repeatedly arranged in the first horizontal direction X. In other words, the line cut region BLCR of one lower bit line BLA may be formed in correspondence to a total of four upper bit lines, i.e., the first to fourth upper bit lines BL1B, BL2B, BL3B, and BL4B, the bypass bit lines BB corresponding to the total of four upper bit lines, i.e., the first to fourth upper bit lines BL1B, BL2B, BL3B, and BL4B, may be arranged in the line cut region BLCR, and this may be referred to as a 4:1 bypass bit line matching structure.

However, in some embodiments, the memory device 110 may have an n:1 bypass bit line matching structure, wherein n may have any value greater than or equal to 2. In some embodiments, the memory device 110 may have an n:1 bypass bit line matching structure, wherein n may have any value between 2 and 50 (e.g., a value greater than or equal to 2 and less than or equal to 50). For example, when n bypass bit lines BB are arranged in one line cut region BLCR, the first segment SEG1 and the second segment SEG2 of the first lower bit line BL1A may be arranged at both sides of the n bypass bit lines BB, n-1 uncut lower bit lines may be arranged beside the first lower bit line BL1A, and a lower bit line unit including the first lower bit line BL1A and the n-1 uncut lower bit lines may be repeatedly arranged. As described above, the line cut region BLCR of one lower bit line BLA may be formed in correspondence to a total of n upper bit lines may be formed, and bypass bit lines BB corresponding to the total of n upper bit lines may be arranged in the line cut region BLCR.

In embodiments, as n bypass bit lines BB are arranged in a row in one line cut region BLCR, the first length L1 of the first lower connection line CL1A may have a relatively small value, and accordingly, the area overhead of the bonding pad region BLBP_R may be reduced, in other words, the bonding pad region BLBP_R may be area-efficiently designed.

In general, in a bonding-type memory device in which a cell area and a peripheral circuit area are individually formed on a wafer and bonded to each other, a routing wiring length for electrically connecting a bit line in the cell area to a page buffer in the peripheral circuit area may relatively increase, thereby decreasing device performance. In particular, when two or more cell areas are bonded to improve integration, it is needed to design a routing wiring of a second-layer bit line through an edge region around a cell array even though a first-layer bit line is connected to a peripheral circuit through a through via, and thus, there may occur the access speed difference between a first-layer cell and a second-layer cell.

However, according to embodiments, the lower bit line BLA of the first cell area CE1 and the upper bit line BLB of the second cell area CE2 may be connected to a peripheral circuit through the lower through via IOA in the bonding pad region BLBP_R, and thus, the access speed difference between the first memory cell array MCA of the first cell area CE1 and the second memory cell array MCB of the second cell area CE2 may be reduced and/or prevented.

In addition, a plurality of bypass bit lines spaced apart from each other are sequentially arranged between the first segment SEG1 and the second segment SEG2 of the first lower bit line BL1A, and thus, the length of the first lower bit line BL1A may be relatively small, and accordingly, the bonding pad region BLBP_R may be area-efficiently designed.

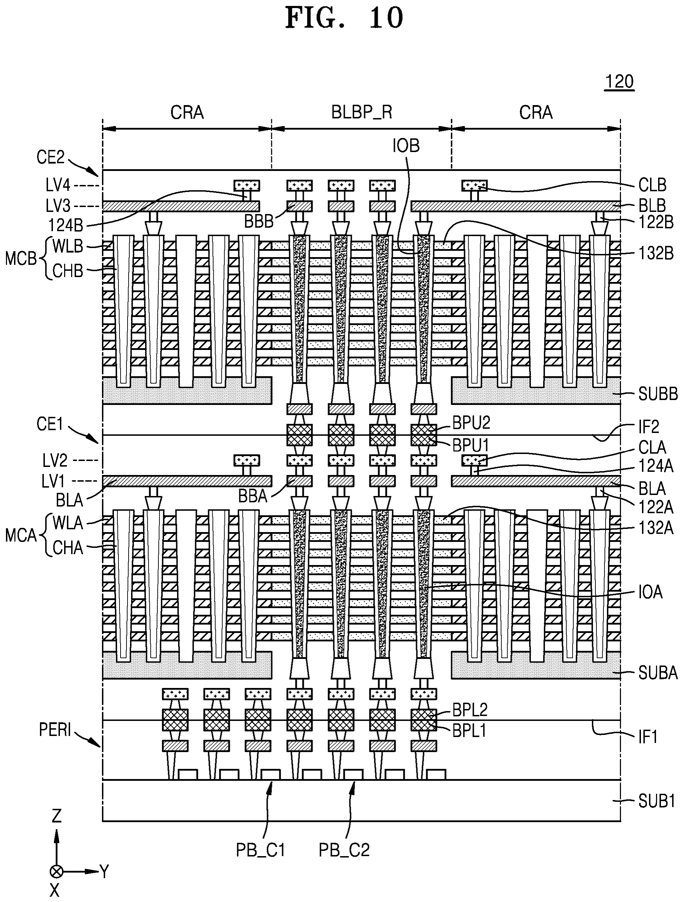

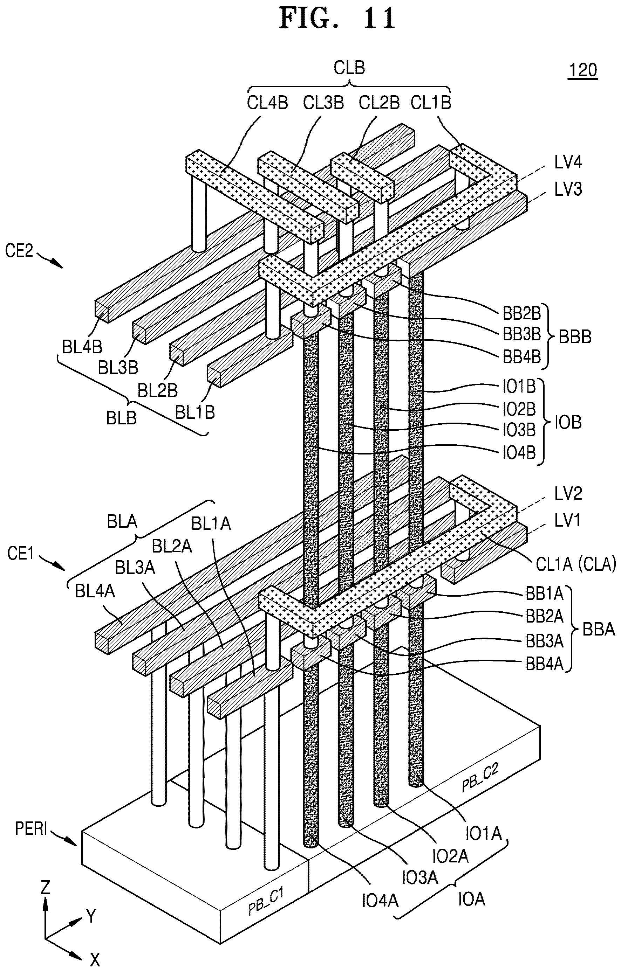

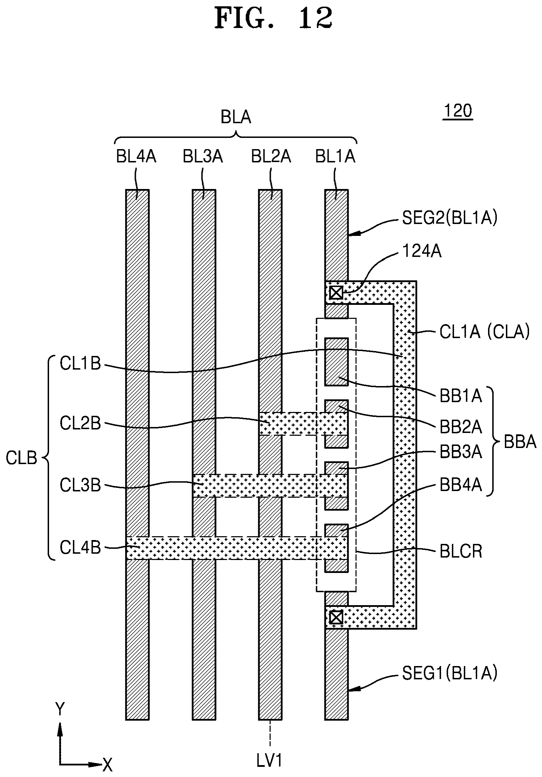

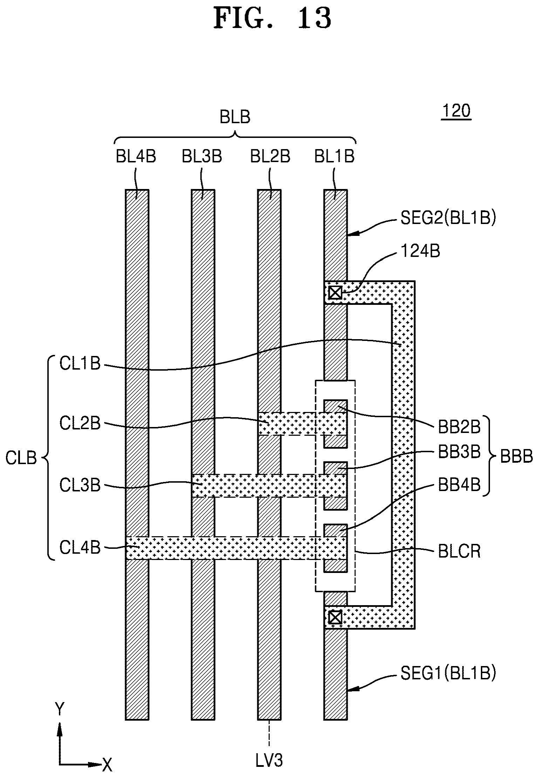

FIG. 10 is a cross-sectional view illustrating a memory device 120 according to embodiments. FIG. 11 is a perspective view schematically illustrating a bit line connection structure of the memory device 120 of FIG. 10. FIG. 12 is a plan layout diagram illustrating an arrangement of lower bit lines of FIG. 11. FIG. 13 is a plan layout diagram illustrating an arrangement of upper bit lines of FIG. 11.

Referring to FIGS. 10 to 13, the peripheral circuit area PERI, the first cell area CE1, and the second cell area CE2 may be sequentially stacked in the vertical direction Z. In embodiments, the rear face of the first cell area CE1 may be attached to the front face of the peripheral circuit area PERI, and the rear face of the second cell area CE2 may be attached to the front face of the first cell area CE1. The first memory cell array MCA may be arranged in the first cell area CE1, and the second memory cell array MCB may be arranged in the second cell area CE2.

In embodiments, in the first cell area CE1, the distance between the lower bit line BLA and the peripheral circuit area PERI may be greater than the distance between the first memory cell array MCA and the peripheral circuit area PERI. In addition, in the second cell area CE2, the distance between the upper bit line BLB and the peripheral circuit area PERI may be greater than the distance between the second memory cell array MCB and the peripheral circuit area PERI.

The first memory cell array MCA of the first cell area CE1 may be connected to the lower bit line BLA through the bit line contact 122A. The lower bit line BLA may be disposed at the first vertical level LV1 and electrically connected to the lower bonding pads BPL1 and BPL2 via the lower through via IOA. The lower bit line BLA may be electrically connected to the lower connection line CLA disposed at the second vertical level LV2 higher than the first vertical level LV1.

The second memory cell array MCB of the second cell area CE2 may be connected to the upper bit line BLB through the bit line contact 122B. The upper bit line BLB may be disposed at the third vertical level LV3 and electrically connected to the upper bonding pads BPU1 and BPU2 via the upper through via IOB.

The first cell page buffer PB_C1 may be electrically connected to the lower bit line BLA via the lower bonding pads BPL1 and BPL2 (and/or the lower through via IOA and the lower connection line CLA). The second cell page buffer PB_C2 may be electrically connected to lower bypass bit lines BBA via the lower bonding pads BPL1 and BPL2 (and/or the lower through via IOA and the lower connection line CLA) and electrically connected to the upper bit line BLB via the upper bonding pads BPU1 and BPU2 (and/or the upper through via IOB and the upper connection line CLB). A portion of the upper bit line BLB may be electrically connected to the upper through via IOB via upper bypass bit lines BBB and the upper connection line CLB.

In embodiments, the lower bit line BLA may include the first to fourth lower bit lines BL1A, BL2A, BL3A, and BL4A, and the upper bit line BLB may include the first to fourth upper bit lines BL1B, BL2B, BL3B, and BL4B. The first to fourth lower bit lines BL1A, BL2A, BL3A, and BL4A may extend in the second horizontal direction Y at the first vertical level LV1, and the first to fourth upper bit lines BL1B, BL2B, BL3B, and BL4B may extend in the second horizontal direction Y at the third vertical level LV3 higher than the first vertical level LV1.

In embodiments, the first lower bit line BL1A may include the first segment SEG1 and the second segment SEG2 spaced apart from each other with the line cut region BLCR therebetween. Each of the first segment SEG1 and the second segment SEG2 may extend in the second horizontal direction Y, and the second segment SEG2 may be spaced apart from and arranged on a straight line with the first segment SEG1 in the second horizontal direction Y.

In embodiments, the second to fourth lower bit lines BL2A, BL3A, and BL4A may have no line cut region, each of the second to fourth lower bit lines BL2A, BL3A, and BL4A may extend as a single line entirely across the bonding pad region BLBP_R.

In embodiments, in the line cut region BLCR, first to fourth lower bypass bit lines BB1A, BB2A, BB3A, and BB4A may be spaced apart from the first lower bit line BL1A. The first to fourth lower bypass bit lines BB1A, BB2A, BB3A, and BB4A may be arranged on a straight line in the second horizontal direction Y. The first to fourth lower bypass bit lines BB1A, BB2A, BB3A, and BB4A may be disposed at the first vertical level LV1 and have upper surfaces at the same vertical level as that of the upper surface of the first lower bit line BL1A.

In embodiments, the first segment SEG1 and the second segment SEG2 of the first lower bit line BL1A may be electrically connected to each other via the lower connection line CLA. In embodiments, as shown in FIG. 11, the first lower connection line CL1A may be disposed at the second vertical level LV2 higher than the first vertical level LV1 of the first segment SEG1 and the second segment SEG2.

In embodiments, the first upper bit line BL1B may include the first segment SEG1 and the second segment SEG2 spaced apart from each other with the line cut region BLCR therebetween. Each of the first segment SEG1 and the second segment SEG2 of the first upper bit line BL1B may extend in the second horizontal direction Y, and the second segment SEG2 may be spaced apart from and arranged on a straight line with the first segment SEG1 in the second horizontal direction Y.

In embodiments, in the line cut region BLCR, second to fourth upper bypass bit lines BB2B, BB3B, and BB4B may be spaced apart from the first upper bit line BL1B. The second to fourth upper bypass bit lines BB2B, BB3B, and BB4B may be arranged on a straight line in the second horizontal direction Y. The second to fourth upper bypass bit lines BB2B, BB3B, and BB4B may be disposed at the third vertical level LV3 and have upper surfaces at the same vertical level as that of the upper surface of the first upper bit line BL1B.

In embodiments, the second upper bit line BL2B may be electrically connected to the second upper bypass bit line BB2B via the second upper connection line CL2B, the third upper bit line BL3B may be electrically connected to the third upper bypass bit line BB3B via the third upper connection line CL3B, and the fourth upper bit line BL4B may be electrically connected to the fourth upper bypass bit line BB4B via the fourth upper connection line CL4B. The first segment SEG1 and the second segment SEG2 of the first upper bit line BL1B may be electrically connected to each other via a first upper connection line CL1B. In embodiments, as shown in FIG. 11, the first to fourth upper connection lines CL1B, CL2B, CL3B, and CL4B may be disposed at the fourth vertical level LV4 higher than the third vertical level LV3 of the first segment SEG 1 and the second segment SEG2 of the first upper bit line BL1B. The first to fourth upper connection lines CL1B to CL4B may be connected to the first to fourth further upper bit lines BL1B to BL4B by corresponding connection vias 124B.

In embodiments, the second to fourth upper bypass bit lines BB2B, BB3B, and BB4B may be disposed at positions vertically overlapping second to fourth lower bypass bit lines BB2A, BB3A, and BB4A, respectively, disposed at positions vertically overlapping the second to fourth lower through vias IO2A, IO3A, and IO4A, respectively, or disposed at positions vertically overlapping second to fourth upper through vias IO2B, IO3B, and IO4B, respectively.

In embodiments, the second upper bit line BL2B may be electrically connected to the second cell page buffer PB_C2 arranged in the peripheral circuit area PERI via the second upper bypass bit line BB2B, the second upper through via IO2B, the second lower bypass bit line BB2A, and the second lower through via IO2A. Accordingly, a relatively short electrical path from the second upper bit line BL2B to the second cell page buffer PB_C2 may be provided.

In addition, like the second upper bypass bit line BB2B, the third upper bit line BL3B may be electrically connected to the second cell page buffer PB_C2 arranged in the peripheral circuit area PERI via the third upper bypass bit line BB3B, the third upper through via IO3B, the third lower bypass bit line BB3A, and the third lower through via IO3A. In addition, like the second upper bypass bit line BB2B, the fourth upper bit line BL4B may be electrically connected to the second cell page buffer PB_C2 arranged in the peripheral circuit area PERI via the fourth upper bypass bit line BB4B, the fourth upper through via IO4B, the fourth lower bypass bit line BB4A, and the fourth lower through via IO4A. In addition, the first upper bit line BL1B may be electrically connected to the second cell page buffer PB_C2 arranged in the peripheral circuit area PERI via the first upper through via IO1B, the first lower bypass bit line BB1A, and the first lower through via IO1A.

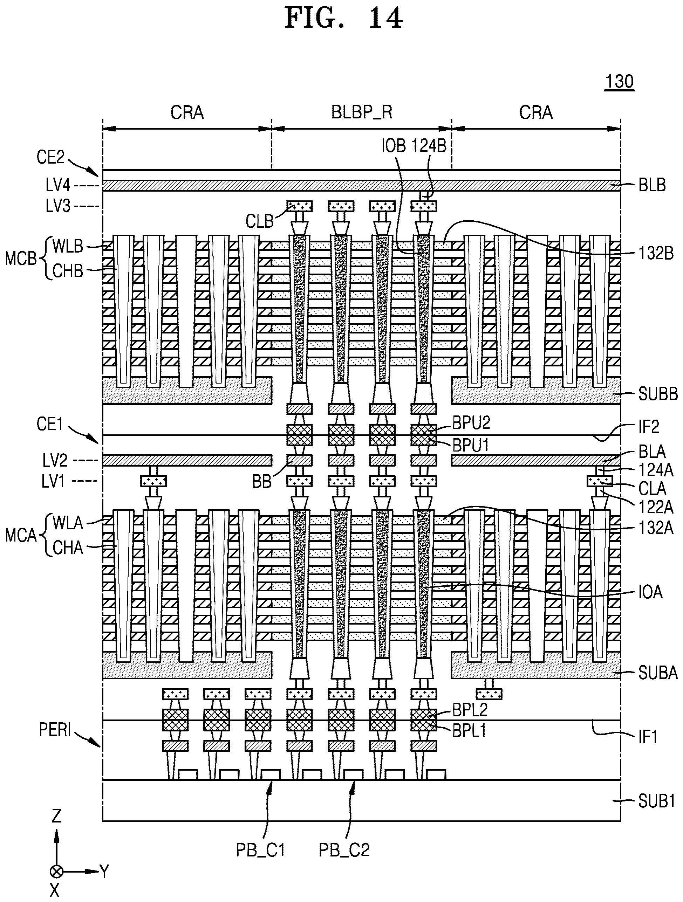

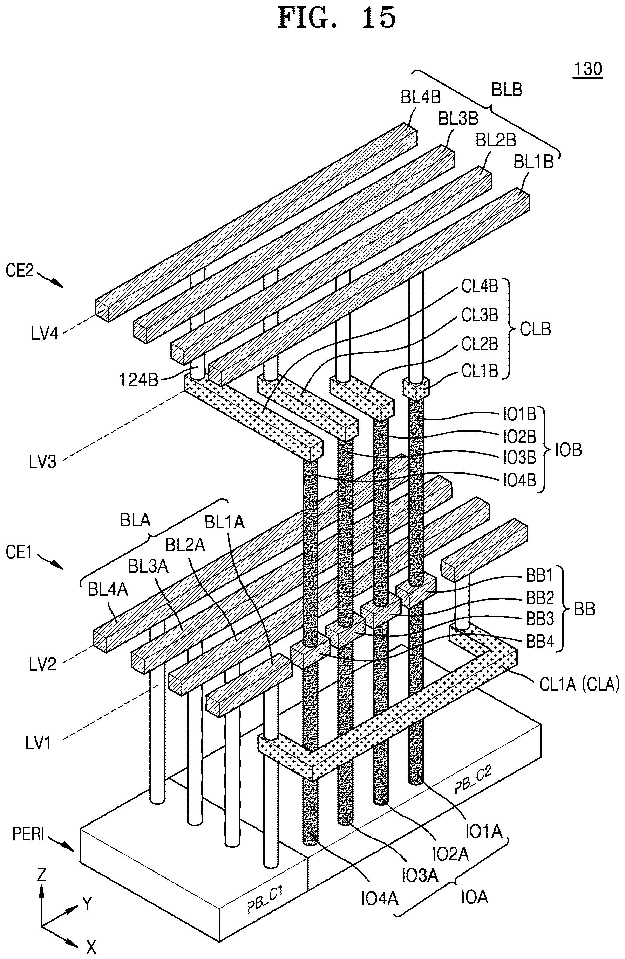

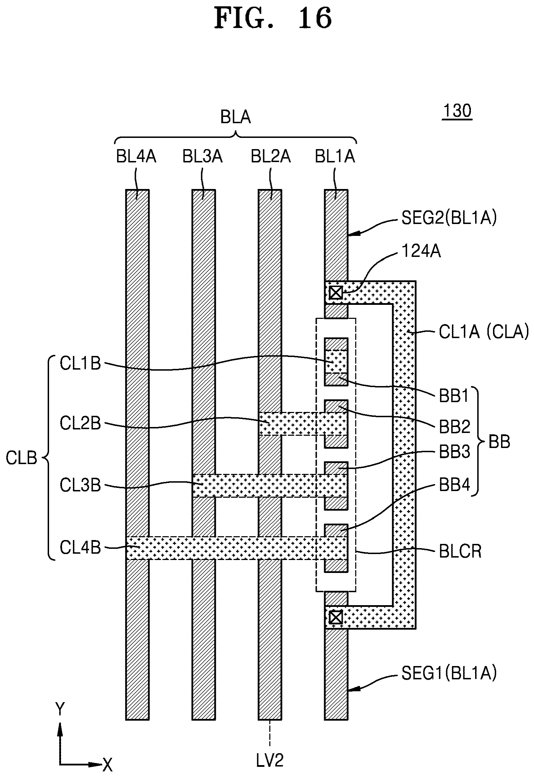

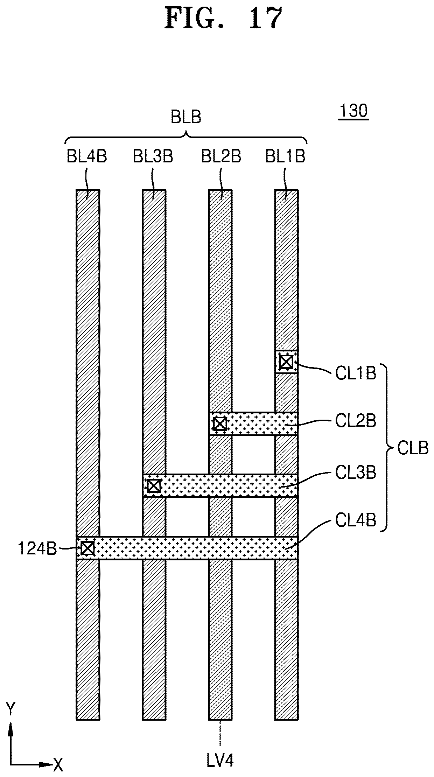

FIG. 14 is a cross-sectional view illustrating a memory device 130 according to embodiments. FIG. 15 is a perspective view schematically illustrating a bit line connection structure of the memory device 130 of FIG. 14. FIG. 16 is a plan layout diagram illustrating an arrangement of lower bit lines of FIG. 14. FIG. 17 is a plan layout diagram illustrating an arrangement of upper bit lines of FIG. 14.

Referring to FIGS. 14 to 17, the peripheral circuit area PERI, the first cell area CE1, and the second cell area CE2 may be sequentially stacked in the vertical direction Z. In embodiments, the rear face of the first cell area CE1 may be attached to the front face of the peripheral circuit area PERI, and the rear face of the second cell area CE2 may be attached to the front face of the first cell area CE1. The first memory cell array MCA may be arranged in the first cell area CE1, and the second memory cell array MCB may be arranged in the second cell area CE2.

The first memory cell array MCA of the first cell area CE1 may be connected to the lower bit line BLA through the bit line contact 122A. The lower bit line BLA may be disposed at the second vertical level LV2 and electrically connected to the lower bonding pads BPL1 and BPL2 via the lower through via IOA. The lower bit line BLA may be electrically connected to the lower connection line CLA disposed at the first vertical level LV1 lower than the second vertical level LV2.

The second memory cell array MCB of the second cell area CE2 may be connected to the upper bit line BLB through the bit line contact 122B. The upper bit line BLB may be disposed at the fourth vertical level LV4 and electrically connected to the upper connection line CLB disposed at the third vertical level LV3 lower than the fourth vertical level LV4. The upper connection line CLB may be electrically connected to the bypass bit lines BB of the first cell area CE1 via the upper through via IOB. In embodiments, the upper bit line BLB may be electrically connected to the second cell page buffer PB_C2 arranged in the peripheral circuit area PERI via the upper connection line CLB, the upper through via IOB, the upper bonding pads BPU1 and BPU2, the bypass bit lines BB, the lower through via IOA, and the lower bonding pads BPL1 and BPL2.

Although FIGS. 14 and 15 show that the upper connection line CLB is disposed at a vertical level higher than that of the upper through via IOB and on the upper surface of the upper through via IOB, in some embodiments, the upper connection line CLB may be disposed at a vertical level lower than that of the upper through via IOB, and for example, the upper connection line CLB may be connected to the lower surface of the upper through via IOB. In this case, the upper bit line BLB may be electrically connected to the second cell page buffer PB_C2 arranged in the peripheral circuit area PERI via the upper through via IOB, the upper connection line CLB, the upper bonding pads BPU1 and BPU2, the bypass bit lines BB, the lower through via IOA, and the lower bonding pads BPL1 and BPL2.

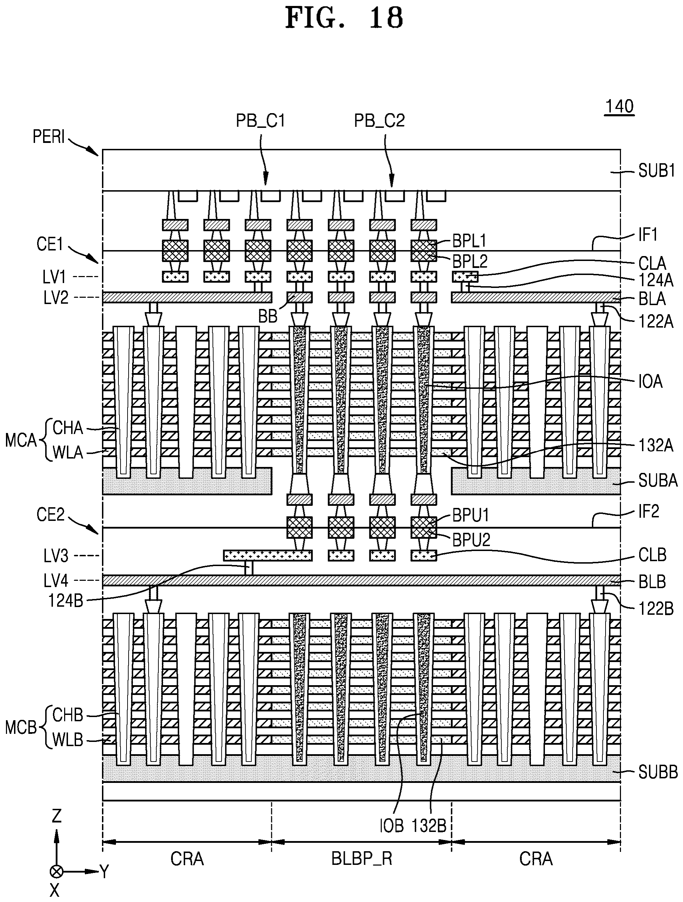

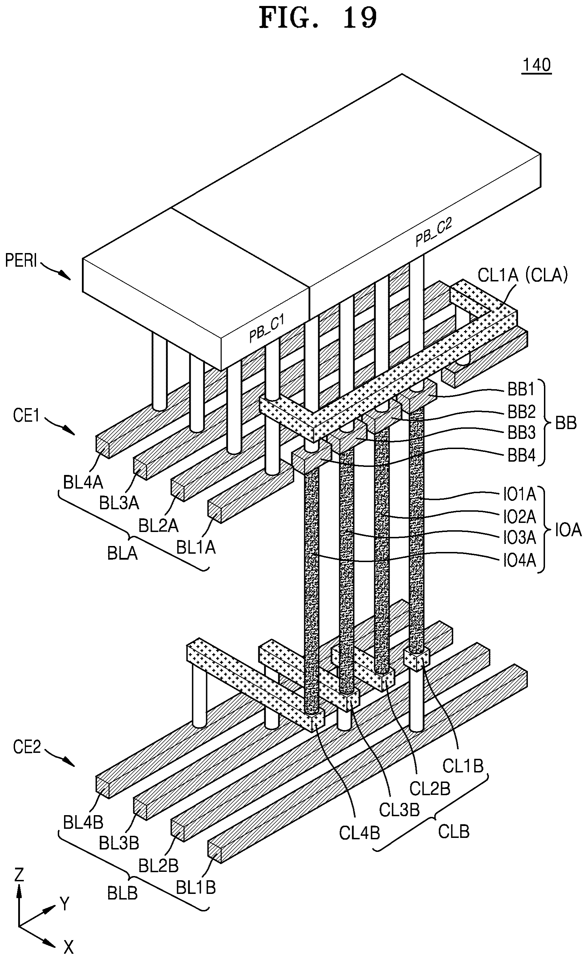

FIG. 18 is a cross-sectional view illustrating a memory device 140 according to embodiments. FIG. 19 is a perspective view schematically illustrating a bit line connection structure of the memory device 140 of FIG. 18.

Referring to FIGS. 18 and 19, the second cell area CE2, the first cell area CE1, and the peripheral circuit area PERI may be sequentially stacked in the vertical direction Z. In embodiments, the rear face of the first cell area CE1 may be attached to the front face of the second cell area CE2, and the front face of the peripheral circuit area PERI may be attached to the front face of the first cell area CE1. The first memory cell array MCA may be arranged in the first cell area CE1, and the second memory cell array MCB may be arranged in the second cell area CE2.

In embodiments, the second cell area CE2 may include the upper bit line BLB, the first cell area CE1 may include the lower bit line BLA. The lower bit line BLA may be disposed at a vertical level higher than that of the upper bit line BLB, and the vertical distance between the lower bit line BLA and the peripheral circuit area PERI may be less than the vertical distance between the upper bit line BLB and the peripheral circuit area PERI.

The memory device 140 described with reference to FIGS. 18 and 19 may have technical features similar to those of the memory device 110 described with reference to FIGS. 5 to 9 except that the stacking order of the second cell area CE2, the first cell area CE1, and the peripheral circuit area PERI in the memory device 140 described with reference to FIGS. 18 and 19 is reversed to the stacking order of the second cell area CE2, the first cell area CE1, and the peripheral circuit area PERI in the memory device 110 described with reference to FIGS. 5 to 9, and thus, a detailed description of the memory device 140 is omitted herein.

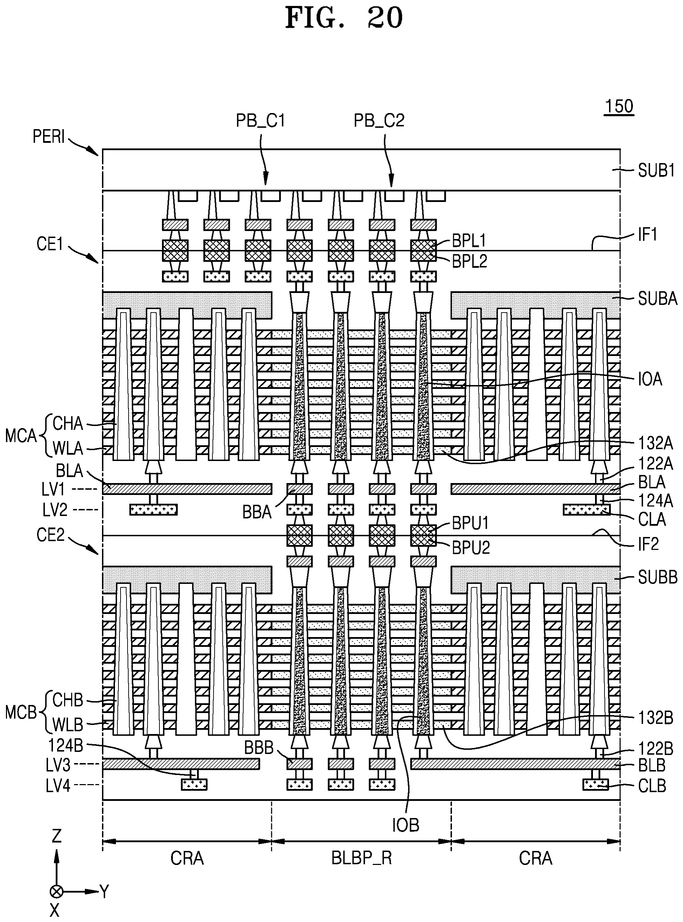

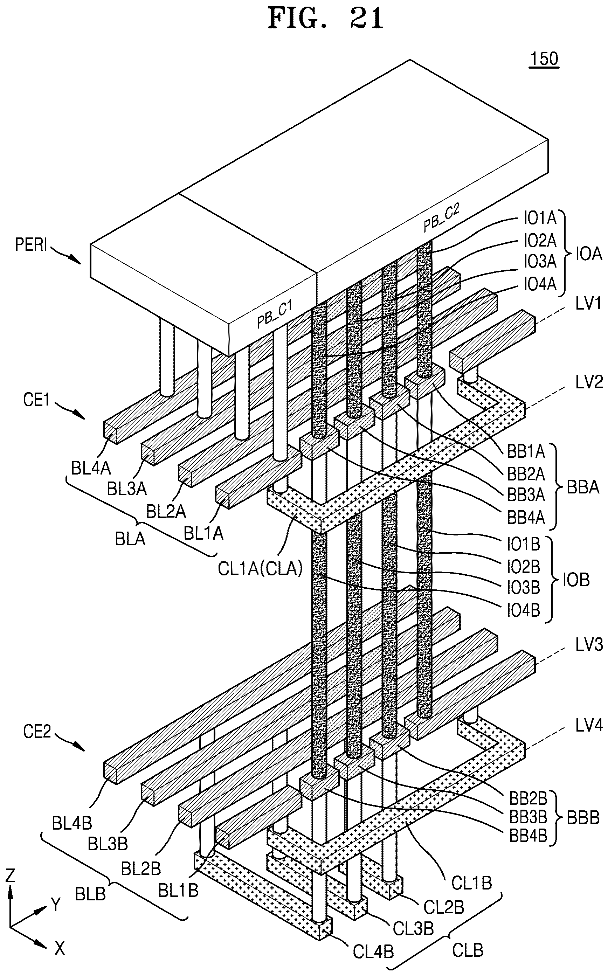

FIG. 20 is a cross-sectional view illustrating a memory device 150 according to embodiments. FIG. 21 is a perspective view schematically illustrating a bit line connection structure of the memory device 150 of FIG. 20.

Referring to FIGS. 20 and 21, the second cell area CE2, the first cell area CE1, and the peripheral circuit area PERI may be sequentially stacked in the vertical direction Z. In embodiments, the front face of the first cell area CE1 may be attached to the rear face of the second cell area CE2, and the front face of the peripheral circuit area PERI may be attached to the rear face of the first cell area CE1. The first memory cell array MCA may be arranged in the first cell area CE1, and the second memory cell array MCB may be arranged in the second cell area CE2.

The memory device 150 described with reference to FIGS. 20 and 21 may have technical features similar to those of the memory device 120 described with reference to FIGS. 10 to 13 except that the stacking order of the second cell area CE2, the first cell area CE1, and the peripheral circuit area PERI in the memory device 150 described with reference to FIGS. 20 and 21 is reversed to the stacking order of the second cell area CE2, the first cell area CE1, and the peripheral circuit area PERI in the memory device 120 described with reference to FIGS. 10 to 13, and thus, a detailed description of the memory device 150 is omitted herein.

According to the embodiments described above, bit lines of a first cell area and bit lines of a second cell area may be connected to a peripheral circuit through a through via in a bonding pad region, and thus, the access speed difference between a first memory cell array of the first cell area and a second memory cell array of the second cell area may be reduced or prevented. In addition, the length of a connection line connecting segments of a lower bit line may be relatively small, and accordingly, the bonding pad region may be area-efficiently designed.

Embodiments are set out in the following Clauses:
Clause 1. A memory device comprising:
   a peripheral circuit area;
   a first cell area disposed on the peripheral circuit area and comprising a plurality of lower bit lines and a plurality of bypass bit lines, wherein the plurality of lower bit lines comprises a cut lower bit line comprising a first segment and a second segment spaced apart from each other with a line cut region therebetween and one or more normal bit lines spaced apart from the cut lower bit line in a first horizontal direction and extending in a second horizontal direction, and wherein the plurality of bypass bit lines are spaced apart from each other in the second horizontal direction in the line cut region; and
   a second cell area disposed on the first cell area and comprising a plurality of upper bit lines electrically connected to the plurality of bypass bit lines.
Clause 2. The memory device of Clause 1, wherein a number of the plurality of bypass bit lines arranged in the line cut region is n, a number of the plurality of upper bit lines is n, and n is a natural number equal to or greater than 2.
Clause 3. The memory device of Clause 2, wherein n is a natural number in a range of 2 to 50.
Clause 4. The memory device of any of Clauses 1-3, wherein
   the first cell area further comprises:
      a plurality of word lines spaced apart from each other in a vertical direction in a main cell region;
      a plurality of channel structures extending in the vertical direction and passing through the plurality of word lines in the main cell region;
      a plurality of sacrificial layers spaced apart from each other in the vertical direction in a bonding pad region; and
      a plurality of through vias extending in the vertical direction and passing through the plurality of sacrificial layers in the bonding pad region,
   wherein the plurality of through vias are electrically connected to the plurality of bypass bit lines, respectively.

While the inventive concept has been particularly shown and described with reference to embodiments thereof, it will be understood that various changes in form and details may be made therein without departing from the scope of the following claims.

## Claims

1. A memory device comprising:
a peripheral circuit area (PERI);
a first cell area (CE1) disposed at a vertical level different from that of the peripheral circuit area (PERI) and comprising a plurality of lower bit lines (BLA) and a plurality of bypass bit lines (BB), wherein the plurality of lower bit lines comprises (BLA) a first lower bit line (BLA1) comprising a first segment (SEG1) and a second segment (SEG2) spaced apart from each other with a line cut region therebetween and a second lower bit line (BLA2) spaced apart from the first lower bit line (BLA1) in a first horizontal direction and extending in a second horizontal direction, and wherein the plurality of bypass bit lines (BB) are spaced apart from each other in the second horizontal direction in the line cut region; and
a second cell area (CE2) comprising a plurality of upper bit lines (BLB) electrically connected to the plurality of bypass bit lines (BB), the first cell area (CE1) being disposed between the peripheral circuit area (PERI) and the second cell area (CE2).

2. The memory device of claim 1, wherein the plurality of bypass bit lines (BB) are arranged between the first segment (SEG1) and the second segment (SEG2) of the first lower bit line (BLA1).

3. The memory device of claim 1 or claim 2, wherein the plurality of bypass bit lines (BB) are arranged on a straight line with the first segment (SEG1) of the first lower bit line (BLA1).

4. The memory device of any preceding claim, wherein
the first cell area (CE1) further comprises a lower connection line (CLA) including a portion spaced apart from the first segment (SEG1) and the second segment (SEG2) in the first horizontal direction and electrically connecting the first segment (SEG1) and the second segment (SEG2) to each other.

5. The memory device of claim 4, wherein
the lower connection line (CLA) has a first length in the second horizontal direction, and
the first length is greater than a length of the line cut region in the second horizontal direction.

6. The memory device of any preceding claim, wherein
the first cell area (CE1) further comprises:
a plurality of word lines (WLA) spaced apart from each other in a vertical direction in a main cell region (CRA);
a plurality of channel structures (CHA) extending in the vertical direction and passing through the plurality of word lines (WLA) in the main cell region (CRA);
a plurality of sacrificial layers (132A) spaced apart from each other in the vertical direction in a bonding pad region (BLBP_R); and
a plurality of through vias (IOA) extending in the vertical direction and passing through the plurality of sacrificial layers (132A) in the bonding pad region (BLBP_R),
wherein the plurality of through vias (IOA) are electrically connected to the plurality of bypass bit lines (BB), respectively.

7. The memory device of claim 6, wherein
the peripheral circuit area (PERI) comprises:
a substrate (SUB1);
a first cell page buffer (PB_C1) disposed on the substrate (SUB1); and
a second cell page buffer (PB_C2) disposed on the substrate (SUB1),
wherein the plurality of upper bit lines (BLB) are electrically connected to the second cell page buffer (PB_C2) via the plurality of bypass bit lines (BB) and the plurality of through vias (IOA).

8. The memory device of claim 6 or claim 7, wherein
the second cell area (CE2) further comprises a plurality of upper connection lines (CLB) electrically connected to the plurality of upper bit lines (BLB) and extending in the first horizontal direction,
wherein the plurality of upper connection lines (CLB) are disposed at a vertical level different from that of the plurality of upper bit lines (BLB).

9. The memory device of any preceding claim, wherein
a number of the plurality of bypass bit lines (BB) arranged in the line cut region is n, which is a natural number equal to or greater than 2,
a number of the plurality of upper bit lines (BLB) is n.

10. The memory device of claim 9, wherein n is a natural number in a range of 2 to 50.

11. The memory device of claim 9 or claim 10, wherein
a lower bit line unit comprises the first lower bit line (BL1A) and one or more second lower bit lines (BL2A, BL3A, BL4A),
an upper bit line unit comprises the plurality of upper bit lines (BLB), and
the lower bit line unit and the upper bit line unit are repeatedly arranged in the first horizontal direction.

12. The memory device of any preceding claim, wherein:
the first cell area (CE1) is disposed on the peripheral circuit area (PERI);
the first lower bit line (BLA1) is a cut lower bit line and the second lower bit line (BLA2) is a normal bit line; and
the second cell area (CE2) is disposed on the first cell area (CE1).
